# EUROPEAN PATENT APPLICATION

(11) **EP 4 746 673 A2**
(43) Date of publication of application: **20.05.2026**
(21) Application number: 25215927.2
(22) Date of filing: 14.11.2025
(51) Int. Cl.: H10P 74/00, H10W 90/20

(54) **CHIP STACK PACKAGE AND MANUFACTURING METHOD OF THE CHIP STACK PACKAGE**

(30) Priority: 18.11.2024 KR 20240163963
(71) Applicant: SK hynix Inc., Bubal-eub Icheon-si Gyeonggi-do 17336 (KR)
(72) Inventor: PARK, Wan Choon, 17336 Icheon-si, Gyeonggi-do (KR); LIM, Jung Hwa, 17336 Icheon-si, Gyeonggi-do (KR); JANG, Min Ju, 17336 Icheon-si, Gyeonggi-do (KR); SON, Ho Young, 17336 Icheon-si, Gyeonggi-do (KR)
(74) Representative: Isarpatent

(57) **Abstract**

Embodiments of the present disclosure provide a chip stack package including a first semiconductor chip having a front bump on a first surface, a second semiconductor chip stacked on a second surface of the first semiconductor chip opposite the first surface, a carrier bump bonded to the front bump, a mold member surrounding the first semiconductor chip, the second semiconductor chip, and the carrier bump, and an external connection bump disposed on the carrier bump.

## Description

### TECHNICAL FIELD

The embodiments of the present disclosure relate to a chip stack package and a manufacturing method of a chip stack package.

### BACKGROUND

A chip stack package or a chip stacking package may be a semiconductor package which expands functions and increases capacity and integration by stacking multiple semiconductor chips. A Through-Silicon-Via (TSV) stack package is a chip stack package in which a Through-Silicon-Via (TSV) is formed on a semiconductor chip. The semiconductor chips are electrically connected to each other using the TSV.

In a TSV stack package, a bump or hybrid bonding may be used for connection between chips.

A TSV stack package may include a base chip, a plurality of core chips stacked on the base chip, and a mold member sealing the base chip and the core chips.

### SUMMARY

Embodiments of the disclosure may provide a chip stack package including a first semiconductor chip having a front bump on a first surface, a second semiconductor chip stacked on a second surface of the first semiconductor chip opposite the first surface, a carrier bump bonded to the front bump, a mold member surrounding the first semiconductor chip, the second semiconductor chip, and the carrier bump, and an external connection bump disposed on the carrier bump.

Embodiments of the disclosure may provide a chip stack package including a base die having a front bump on a first surface, a core middle die stacked on a second surface of the base die opposite to the first surface, a core top die stacked on the core middle die, a carrier bump bonded to the front bump, a mold member surrounding the base die, the core middle die, the core top die, and the carrier bump, and an external connection bump disposed on the carrier bump.

Embodiments of the disclosure may provide a manufacturing method of a chip stack package including forming a carrier bump on a carrier substrate, stacking a first semiconductor chip having a front bump on the carrier substrate and bonding the front bump to the carrier bump, stacking a second semiconductor chip on the first semiconductor chip, forming a mold member, which surrounds the first semiconductor chip, the second semiconductor chip, and the carrier bump, on the carrier substrate, removing the carrier substrate, and forming an external connection bump on the carrier bump exposed by removing the carrier substrate.

Embodiments of the disclosure may provide a manufacturing method of a chip stack package including forming a carrier bump on a carrier substrate, stacking a first semiconductor chip having a front bump including a conductive pillar and a solder layer disposed on the conductive pillar on the carrier substrate, and bonding the front bump to the carrier bump, stacking a second semiconductor chip on the first semiconductor chip, forming a mold member, which surrounds the first semiconductor chip, the second semiconductor chip, and the carrier bump, on the carrier substrate, removing the carrier substrate, polishing a surface exposed by the removal of the carrier substrate to expose the conductive pillar, and forming an external connection bump on the conductive pillar.

### BRIEF DESCRIPTION OF THE DRAWINGS

FIG. 1 is a cross-sectional view of a chip stack package according to an embodiment of the present disclosure.
FIG. 2 is an enlarged view of section A of FIG. 1.
FIG. 3 and FIG. 4 are cross-sectional views illustrating a first front bump, a carrier bump, an external connection bump, and a passivation layer of a chip stack package according to embodiments of the present disclosure.
FIG. 5 is a plan view illustrating a chip stack package according to embodiments of the present disclosure.
FIG. 6A and FIG. 6B are drawings for explaining a second alignment bump according to embodiments of the present disclosure.
FIGs. 7, 8, and 9 are cross-sectional views illustrating chip stack packages according to embodiments of the present disclosure in process order.
FIG. 10 is a cross-sectional view of a chip stack package according to an embodiment of the present disclosure.
FIG. 11 is an enlarged view of section B of FIG. 10.
FIG. 12 and FIG. 13 are cross-sectional views illustrating a first front bump, a carrier bump, an external connection bump, and a passivation layer of a chip stack package according to an embodiment of the present disclosure.
FIG. 14 is a cross-sectional view of a chip stack package according to an embodiment of the present disclosure.
FIG. 15 is an enlarged view of section C of FIG. 14.
FIG. 16 is a cross-sectional view illustrating a first front bump, an external connection bump, and a passivation layer of a chip stack package according to an embodiment of the present disclosure.

### DETAILED DESCRIPTION

Embodiments of the present disclosure are described detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," or "under" another element, the elements may directly contact each other or an intervening element may be disposed between the elements.

Terms such as "vertically," "top," "bottom," "above," "below," "under," "on," "side," "upper," "lower," "front," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

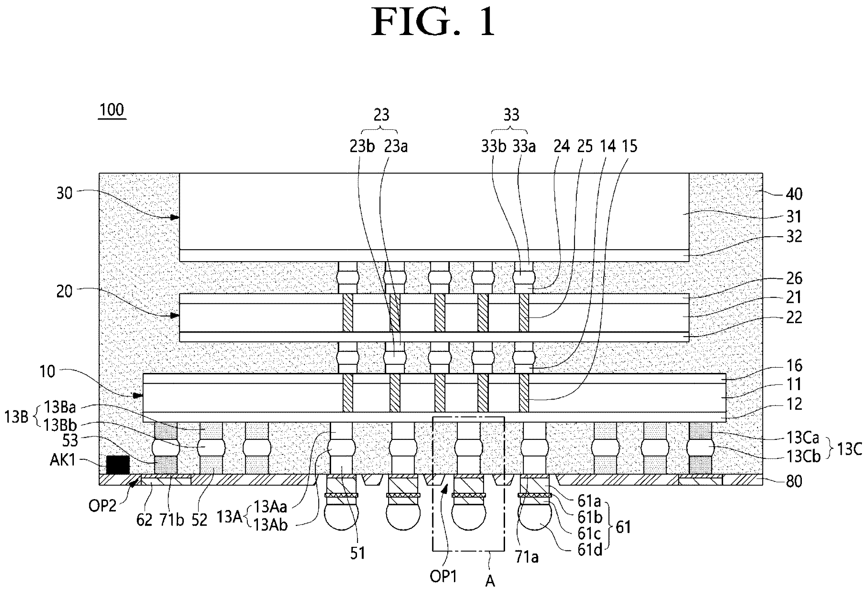

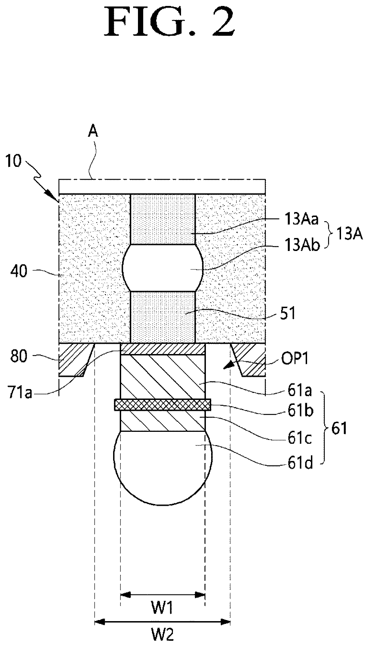

FIG. 1 is a cross-sectional view of a chip stack package according to an embodiment of the present disclosure, and FIG. 2 is an enlarged view of section A of FIG. 1.

Referring to FIG. 1, a chip stack package 100 according to an embodiment of the present disclosure includes first, second, and third semiconductor chips 10, 20 and 30, a mold member 40, a carrier bump 51, and an external connection bump 61. The chip stack package 100 according to an embodiment of the present disclosure further includes a second dummy bump 52, a second test bump 53, a test pad 62, and a passivation layer 80.

The second semiconductor chip 20 is stacked on the first semiconductor chip 10. The third semiconductor chip 30 is stacked on the second semiconductor chip 20. FIG. 1 illustrates an example in which the number of semiconductor chips to be stacked is three, but the number of semiconductor chips to be stacked in the present disclosure may be two or four or more.

In an embodiment, the first semiconductor chip 10 may be a base die, the second semiconductor chip 20 may be a core middle die, and the third semiconductor chip 30 may be a core top die. Although FIG. 1 includes one core middle die, two or more core middle dies may be stacked between the base die and the core top die.

The first semiconductor chip 10 includes a first substrate 11, a first wiring structure 12, a first front bump 13A, a first back bump 14, and a first through-via 15. In addition, the first semiconductor chip 10 further includes a first dummy bump 13B and a first test bump 13C.

The first substrate 11 includes a first substrate body and a first integrated circuit provided on the first substrate body. The first substrate body may include silicon. The first integrated circuit may be implemented in various ways depending on the type of the first semiconductor chip 10. In an embodiment, the second semiconductor chip 20 and the third semiconductor chip 30 may be memory dies, and the first semiconductor chip 10 may be a logic die for controlling the memory dies. The first integrated circuit may include a logic transistor for controlling the memory dies.

The first wiring structure 12 is disposed on the lower surface of the first substrate 11. Although not shown, the first wiring structure 12 includes wirings and an insulating layer. The lower surface of the first wiring structure 12 may constitute a lower surface of the first semiconductor chip 10. In an embodiment, the lower surface of the first semiconductor chip 10 may face toward the passivation layer 80 and away from the second semiconductor chip 20.

The first front bump 13A, the first dummy bump 13B, and the first test bump 13C is disposed on the lower surface of the first semiconductor chip 10.

The first front bump 13A is connected to one of the wirings of the first wiring structure 12. The first front bump 13A is connected to the first integrated circuit through the wiring of the first wiring structure 12. The first front bump 13A may be used for inputting or/and outputting electrical signals, for example, data signals, power supply voltages, and ground voltages.

The first test bump 13C is connected to one of the wirings of the first wiring structure 12. The first test bump 13C is connected to the first integrated circuit through the wiring of the first wiring structure 12. The first test bump 13C is used to test the chip stack package 100. An electrical signal may be applied to the first test bump 13C during a test process. After the test is completed, an electrical signal might not be applied to the first test bump 13C. After the test is completed, the first test bump 13C may be electrically floated.

The first dummy bump 13B may support the first semiconductor chip 10 together with the first front bump 13A and the first test bump 13C, thereby helping to relieve stress applied to the first front bump 13A and the first test bump 13C. In an embodiment, the first dummy bump 13B may fix the first semiconductor chip 10 to a carrier substrate, which will be described later, during the manufacturing process of the chip stack package 100. Thereby, in an embodiment, a warpage in the first semiconductor chip 10 can be suppressed, and solder non-wet problem caused by the warpage can be suppressed. In an embodiment, the first dummy bump 13B may prevent the first semiconductor chip 10 from being pushed down or up due to the pressure of the sealant injected in the process of forming the mold member 40, thereby forming the mold member 40 with a uniform thickness on the lower surface of the first semiconductor chip 10. The first dummy bump 13B might not be used for transmit electrical signal. An electrical signal might not be applied to the first dummy bump 13B. The first dummy bump 13B may be electrically floated.

The first front bump 13A includes a conductive pillar 13Aa under the first wiring structure 12 and a solder layer 13Ab under the conductive pillar 13Aa.

In an embodiment, the conductive pillar 13Aa of the first front bump 13A may be formed of a nickel (Ni) layer. In an embodiment, the conductive pillar 13Aa of the first front bump 13A may be formed of a copper (Cu) layer and a nickel layer under the copper layer.

The solder layer 13Ab of the first front bump 13A may include a tin-silver (Sn-Ag) alloy.

An under bump metallization (UBM) pattern (not shown) may be disposed between the first wiring structure 12 and the first front bump 13A. The UBM pattern may include a barrier metal layer under the first wiring structure 12 and a seed layer under the barrier metal layer. The barrier metal layer may include titanium (Ti). The barrier metal layer may be a titanium layer. The seed layer may include copper. The seed layer may be a copper layer. The conductive pillar 13Aa of the first front bump 13A may be formed by a plating process using a seed layer.

The first dummy bump 13B includes a conductive pillar 13Ba under the first wiring structure 12 and a solder layer 13Bb under the conductive pillar 13Ba. The first test bump 13C includes a conductive pillar 13Ca under the first wiring structure 12 and a solder layer 13Cb under the conductive pillar 13Ca.

The conductive pillar 13Ba of the first dummy bump 13B and the conductive pillar 13Ca of the first test bump 13C may be formed together with the conductive pillar 13Aa of the first front bump 13A in the process of forming the conductive pillar 13Aa of the first front bump 13A. The conductive pillar 13Ba of the first dummy bump 13B and the conductive pillar 13Ca of the first test bump 13C may be composed of the same material as the conductive pillar 13Aa of the first front bump 13A.

The solder layer 13Bb of the first dummy bump 13B and the solder layer 13Cb of the first test bump 13C may be formed together with the solder layer 13Ab of the first front bump 13A in the process of forming the solder layer 13Ab of the first front bump 13A. The solder layer 13Bb of the first dummy bump 13B and the solder layer 13Cb of the first test bump 13C may be composed of the same material as the solder layer 13Ab of the first front bump 13A.

A first insulating layer 16 is disposed on an upper surface of the first substrate 11. The first insulating layer 16 may include an inorganic insulating material and/or an organic insulating material. The inorganic insulating material may include silicon nitride, silicon oxide, and silicon oxynitride. The organic insulating material may include polyimide. The upper surface of the first insulating layer 16 may constitute an upper surface of the first semiconductor chip 10.

The first back bump 14 is disposed on the upper surface of the first semiconductor chip 10. The first back bump 14 is disposed over the first through-via 15 and the first insulating layer 16 surrounding the first through-via 15. The first back bump 14 vertically overlaps with the first through-via 15 and the first insulating layer 16 surrounding the first through-via 15.

In an embodiment, the first back bump 14 may be composed of a copper layer and a nickel layer on the copper layer. In an embodiment, the first back bump 14 may be composed of a nickel layer.

A UBM pattern (not shown) may be disposed between the first back bump 14 and the first through-via 15, and between the first back bump 14 and the first insulating layer 16. The UBM pattern may include a barrier metal layer and a seed layer on the barrier metal layer. The first back bump 14 may be formed on the seed layer by a plating process.

The first through-via 15 vertically penetrates the first substrate 11. The first through-via 15 includes a protrusion which protrudes from the upper surface of the first substrate 11. The first insulating layer 16 surrounds the side surface of the protrusion of the first through-via 15. The upper end of the first through-via 15 is connected to the first back bump 14. The lower end of the first through-via 15 is connected to the first wiring structure 12. The first through-via 15 may be connected to the wiring of the first wiring structure 12. The first through-via 15 may be connected to the first front bump 13A through the wiring of the first wiring structure 12.

The second semiconductor chip 20 includes a second substrate 21, a second wiring structure 22, a second front bump 23, a second back bump 24, and a second through-via 25.

The second substrate 21 includes a second substrate body and a second integrated circuit provided on the second substrate body. The second substrate body may include silicon. The second integrated circuit may be implemented in various ways depending on the type of the second semiconductor chip 20. In an embodiment, the second semiconductor chip 20 may be a memory die, and the second integrated circuit may include a memory cell. The memory may include a volatile memory or a nonvolatile memory. The volatile memory may include DRAM (Dynamic Random Access Memory) and SRAM (Static Random Access Memory). The nonvolatile memory may include NAND, NOR, PRAM (Phase Change Random Access Memory), and MRAM (Magneto-Resistive Random Access Memory).

The second wiring structure 22 is disposed on a lower surface of the second substrate 21. Although not shown, the second wiring structure 22 may include wirings and an insulating layer. The lower surface of the second wiring structure 22 may constitute the lower surface of the second semiconductor chip 20.

The second front bump 23 is disposed on the lower surface of the second semiconductor chip 20. The second front bump 23 is connected to one of the wirings of the second wiring structure 22. The second front bump 23 is connected to the second integrated circuit through the wiring of the second wiring structure 22.

The second front bump 23 includes a conductive pillar 23a under the second wiring structure 22 and a solder layer 23b under the conductive pillar 23a.

In an embodiment, the conductive pillar 23a of the second front bump 23 may be formed of a nickel layer. In an embodiment, the conductive pillar 23a of the second front bump 23 may be formed of a copper layer and a nickel layer under the copper layer. The solder layer 23b of the second front bump 23 may include a tin-silver alloy.

A UBM pattern (not shown) may be disposed between the second wiring structure 22 and the second front bump 23. The UBM pattern may include a barrier metal layer under the second wiring structure 22 and a seed layer under the barrier metal layer. The conductive pillar 23a of the second front bump 23 may be formed by a plating process using the seed layer.

A second insulating layer 26 is disposed on the upper surface of the second substrate 21. The second insulating layer 26 may include an inorganic insulating material and an organic insulating material. The inorganic insulating material may include silicon nitride, silicon oxide, and silicon oxynitride. The organic insulating material may include polyimide. The upper surface of the second insulating layer 26 may constitute the upper surface of the second semiconductor chip 20.

The second back bump 24 is disposed on the upper surface of the second semiconductor chip 20. The second back bump 24 is disposed over the second through-via 25 and the second insulating layer 26 around the second through-via 25. The second back bump 24 vertically overlaps with the second through-via 25 and the second insulating layer 26 around the second through-via 25.

A UBM pattern (not shown) may be disposed between the second back bump 24 and the second through-via 25, and between the second back bump 24 and the second insulating layer 26. The UBM pattern may include a barrier metal layer and a seed layer on the barrier metal layer. The second back bump 24 may be formed by a plating process using the seed layer.

In an embodiment, the second back bump 24 may be composed of a copper layer and a nickel layer on the copper layer. In an embodiment, the second back bump 24 may be composed of a nickel layer.

The second through-via 25 vertically penetrates the second substrate 21. The second through-via 25 includes a protrusion protruding beyond the upper surface of the second substrate 21. The second insulating layer 26 surrounds a side surface of the protrusion of the second through-via 25. The upper end of the second through-via 25 is connected to the second back bump 24. The lower end of the second through-via 25 is connected to the second wiring structure 22. The second through-via 25 may be connected to the wiring of the second wiring structure 22, and may be connected to the second front bump 23 through the wiring of the second wiring structure 22.

The second semiconductor chip 20 is connected to the first semiconductor chip 10 through the second front bump 23. The second front bump 23 of the second semiconductor chip 20 is disposed over the first back bump 14 of the first semiconductor chip 10. The second front bump 23 vertically overlaps the first back bump 14. The solder layer 23b of the second front bump 23 is bonded to the first back bump 14.

The third semiconductor chip 30 includes a third substrate 31, a third wiring structure 32, and a third front bump 33.

The third substrate 31 includes a third substrate body and a third integrated circuit provided on the third substrate body. The third substrate body may include silicon. The thickness of the third substrate 31 may be different from the thickness of the second substrate 21. The third substrate 31 may be thicker than the second substrate 21.

The third integrated circuit may be implemented in various ways depending on the type of the third semiconductor chip 30. In an embodiment, the third semiconductor chip 30 may be a memory die, and the third integrated circuit may include a memory cell.

The third wiring structure 32 may be disposed on the lower surface of the third substrate 31. Although not shown, the third wiring structure 32 may include wirings and an insulating layer. The lower surface of the third wiring structure 32 constitutes the lower surface of the third semiconductor chip 30.

The third front bump 33 is disposed on the lower surface of the third semiconductor chip 30. The third front bump 33 is connected to one of the wirings of the third wiring structure 32. The third front bump 33 is connected to the third integrated circuit through the wiring of the third wiring structure 32.

The third front bump 33 includes a conductive pillar 33a under the third wiring structure 32 and a solder layer 33b under the conductive pillar 33a.

In an embodiment, the conductive pillar 33a of the third front bump 33 may be formed of a nickel layer. In an embodiment, the conductive pillar 33a of the third front bump 33 may be formed of a copper layer and a nickel layer under the copper layer. The solder layer 33b of the third front bump 33 may include a tin-silver alloy.

A UBM pattern (not shown) may be disposed between the third wiring structure 32 and the third front bump 33. The UBM pattern may include a barrier metal layer under the third wiring structure 32 and a seed layer under the barrier metal layer. The conductive pillar 33a of the third front bump 33 may be formed by a plating process using the seed layer.

The third semiconductor chip 30 is connected to the second semiconductor chip 20 through the third front bump 33. The third front bump 33 of the third semiconductor chip 30 is disposed over the second back bump 24. The third front bump 33 vertically overlaps the second back bump 24. The solder layer 33b of the third front bump 33 is bonded to the second back bump 24.

The first front bump 13A of the first semiconductor chip 10 is bonded to the carrier bump 51. The first front bump 13A of the first semiconductor chip 10 disposed over the carrier bump 51. The first front bump 13A vertically overlaps the carrier bump 51. The solder layer 13Ab of the first front bump 13A is bonded to the carrier bump 51.

The carrier bump 51 includes at least one metal. In an embodiment, the carrier bump 51 may be composed of a copper layer and a nickel layer on the copper layer. In an embodiment, the carrier bump 51 may be composed of a nickel layer.

The first dummy bump 13B of the first semiconductor chip 10 is bonded to the second dummy bump 52. The first dummy bump 13B of the first semiconductor chip 10 is disposed over the second dummy bump 52. The first dummy bump 13B vertically overlaps with the second dummy bump 52. The solder layer 13Bb of the first dummy bump 13B is bonded to the second dummy bump 52.

The first test bump 13C of the first semiconductor chip 10 is bonded to the second test bump 53. The first test bump 13C of the first semiconductor chip 10 is disposed over the second test bump 53. The first test bump 13C vertically overlaps the second test bump 53. The solder layer 13Cb of the first test bump 13C is bonded to the second test bump 53.

The second dummy bump 52 and the second test bump 53 may be formed together with the carrier bump 51 in the process of forming the carrier bump 51. The second dummy bump 52 and the second test bump 53 may be composed of the same material as the carrier bump 51.

The mold member 40 covers and surrounds the first, second, and third semiconductor chips 10, 20 and 30, the carrier bump 51, the second dummy bump 52, and the second test bump 53. The mold member 40 protects the first, second, and third semiconductor chips 10, 20 and 30, the carrier bump 51, the second dummy bump 52, and the second test bump 53 from the external environment.

The mold member 40 covers the side surfaces of the first, second, and third semiconductor chips 10, 20 and 30, and the lower surface of the first semiconductor chip 10. The mold member 40 exposes the upper surface of the third semiconductor chip 30. The upper surface of the mold member 40 and the upper surface of the third semiconductor chip 30 may be on the same plane. In an embodiment, because the upper surface of the third semiconductor chip 30 is not covered by the mold member 40, heat generated when the first, second, and third semiconductor chips 10, 20 and 30 operate may be released to the outside of the chip stack package 100 through the upper surface of the third semiconductor chip 30 without interference from the mold member 40.

The mold member 40 may be extended to fill the spaces between the first, second and third semiconductor chips 10, 20 and 30. The mold member 40 may have a molded under-fill (MUF) shape for filling the spaces between the first, second and third semiconductor chips 10, 20 and 30. As another example, the spaces between the first, second and third semiconductor chips 10, 20 and 30 may be filled with an under-fill material different from the mold member 40. As another example, an adhesive layer may be disposed between the first semiconductor chip 10 and the second semiconductor chip 20 and between the second semiconductor chip 20 and the third semiconductor chip 30, thereby attaching the semiconductor chips 10, 20 and 30 to each other.

The mold member 40 may be formed by a molding process using a liquid sealant. The sealant may include an epoxy molding compound (EMC). The epoxy molding compound may include resin and filler.

The lower surface of the carrier bump 51, the lower surface of the second dummy bump 52, and the lower surface of the second test bump 53 is exposed to the lower surface of the mold member 40. The passivation layer 80 is disposed on the lower surface of the mold member 40. A first opening OP1 is formed in the passivation layer 80 through which the carrier bump 51 is exposed. A second opening OP2 is formed in the passivation layer 80 through which the second test bump 53 is exposed. The passivation layer 80 covers the second dummy bump 52. The passivation layer 80 includes an insulating material. The insulating material may include a polymer-based photosensitive material.

The external connection bump 61 is disposed under the carrier bump 51 exposed through a first opening OP1. The upper section of the external connection bump 61 is disposed inside the first opening OP1.

The first opening OP1 has a larger planar area than the carrier bump 51. The external connection bump 61 may have a larger planar area than the carrier bump 51. The external connection bump 61 is disposed under the carrier bump 51 and the mold member 40 around the carrier bump 51. The external connection bump 61 vertically overlaps the carrier bump 51 and the mold member 40 around the carrier bump 51.

The external connection bump 61 includes a first copper layer 61a, a first nickel layer 61b under the first copper layer 61a, a second copper layer 61c under the first nickel layer 61b, and a solder layer 61d under the second copper layer 61c.

The thickness of the first copper layer 61a may be greater than the thickness of the first nickel layer 61b. The first copper layer 61a made of copper having a lower resistivity than nickel may be formed thicker than the first nickel layer 61b to secure the electrical conductivity of the external connection bump 61. In an embodiment, the thickness of a layer may be measured in the vertical direction or stacking direction of, for example, the first, second, and third semiconductor chips 10, 20, and 30.

The first nickel layer 61b is interposed between the first copper layer 61a and the second copper layer 61c. The first nickel layer 61b can suppress the copper included in the first copper layer 61a from diffusing to the interface between the second copper layer 61c and the solder layer 61d. Thereby the generation of thick intermetallic compounds between the second copper layer 61c and the solder layer 61d can be suppressed.

The side surface of the first nickel layer 61b may protrude more in the horizontal direction than the side surface of the first copper layer 61a and the side surface of the second copper layer 61c. The center section of the first nickel layer 61b may vertically overlap with the first copper layer 61a and the second copper layer 61c, and the flange section of the first nickel layer 61b might not vertically overlap with the first copper layer 61a and the second copper layer 61c.

The second copper layer 61c is interposed between the first nickel layer 61b and the solder layer 61d.

Because the nickel-solder intermetallic compound has a higher volume shrinkage rate than the copper-solder intermetallic compound, which makes them more prone to voids and being brittle. Because cracks initiate in the voids and propagate rapidly across the voids, the nickel-solder intermetallic compound is more susceptible to cracking defects than the copper-solder intermetallic compound. According to an embodiment of the present disclosure, because the second copper layer 61c is disposed between the first nickel layer 61b and the solder layer 61d, it is possible to suppress the formation of the nickel-solder intermetallic compound.

A copper-solder intermetallic compound (not shown) may be be generated between the second copper layer 61c and the solder layer 61d. The thickness of the second copper layer 61c is smaller than the thickness of the first copper layer 61a. Because, in an embodiment, the copper included in the first copper layer 61a may be suppressed from diffusing into the interface between the second copper layer 61c and the solder layer 61d by the first nickel layer 61b, and the second copper layer 61c has a smaller thickness than the first copper layer 61a, the copper-solder intermetallic compound may be formed as a thin film.

A first UBM pattern 71a is disposed between the external connection bump 61 and the carrier bump 51, and between the external connection bump 61 and the mold member 40. The first UBM pattern 71a includes a barrier metal layer under the carrier bump 51 and the mold member 40, and a seed layer under the barrier metal layer. The barrier metal layer may include titanium, and the seed layer may include copper. The first copper layer 61a, the first nickel layer 61b, and the second copper layer 61c of the external connection bump 61 may be formed by a plating process using the seed layer of the first UBM pattern 71a.

The test pad 62 is disposed on the second test bump 53 exposed through the second opening OP2. The test pad 62 may have a larger planar area than the second test bump 53. The test pad 62 is disposed below the second test bump 53 and the mold member 40 around the second test bump 53. The test pad 62 vertically overlaps the second test bump 53 and the mold member 40 around the second test bump 53.

In an embodiment, the test pad 62 may be composed of a copper layer and a nickel layer below the copper layer.

A second UBM pattern 71b may be disposed between the test pad 62 and the second test bump 53, and between the test pad 62 and the mold member 40. The second UBM pattern 71b may include a barrier metal layer under the second test bump 53 and the mold member 40, and a seed layer under the barrier metal layer. The barrier metal layer may include titanium, and the seed layer may include copper. The test pad 62 may be formed by a plating process using the seed layer of the second UBM pattern 71b.

The chip stack package 100 may further include a first alignment key AK1. The first alignment key AK1 might not overlap with the first semiconductor chip 10. The first alignment key AK1 may be used as a reference point (e.g., zero point) to determine the position of the external connection bump 61 in the process of forming the external connection bump 61. The first alignment key AK1 may be used as a reference point to determine the position of the test pad 62 in the process of forming the test pad 62. The first alignment key AK1 may be used as a reference point to determine the cutting position of the mold member 40 in the process of cutting the mold member 40 to individualize the chip stack package 100.

In an embodiment, the first alignment key AK1 may be formed together with the carrier bump 51 in the process of forming the carrier bump 51. The first alignment key AK1 may be a bump arranged at the same height level as the carrier bump 51. The side surface of the first alignment key AK1 may be surrounded with the mold member 40, and the lower surface of the alignment key AK1 may be exposed to the lower surface of the mold member 40. The first alignment key AK1 is not used to input or/and output of a data signal, a power voltage, and a ground voltage. An electrical signal might not be applied to the first alignment key AK1. The first alignment key AK1 may be electrically floated.

Referring to FIG. 2, the first opening OP1 of the passivation layer 80 may have a reverse tapered structure in which the width increases as the distance from the mold member 40 increases. As described above, the passivation layer 80 may be formed of a polymer-based photosensitive material. A photosensitive material layer may be formed on the carrier bump 51 and the mold member 40, and the photosensitive material layer may be partially removed by an exposure process and a development process to form a first opening OP1. After the first opening OP1 is formed, the photosensitive material layer may be hardened by a curing process to form a passivation layer 80. During the curing process, the photosensitive material layer may shrink, and the width of the shrinkage of the photosensitive material layer may increase as the distance from the mold member 40 increases. Accordingly, the width of the first opening OP1 may increase as the distance from the mold member 40 increases, and the first opening OP1 may have a reverse tapered structure in which the width increases as the distance from the mold member 40 increases.

The width of the first copper layer 61a of the external connection bump 61 is W1. The minimum width of the first opening OP1 of the passivation layer 80 is W2. W2 is greater than W1. The planar area of the first opening OP1 may be greater than the planar area of the external connection bump 61. The external connection bump 61 and the passivation layer 80 are disposed to be spaced apart from each other. The passivation layer 80 does not contact the external connection bump 61.

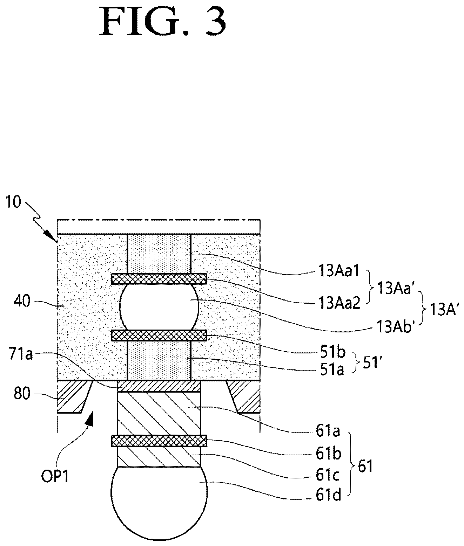

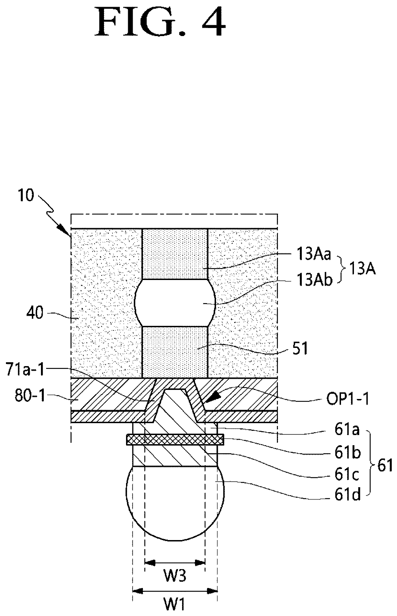

FIG. 3 and FIG. 4 are cross-sectional views illustrating a first front bump, a carrier bump, an external connection bump, and a passivation layer of a chip stack package according to embodiments of the present disclosure.

Referring to FIG. 3, a conductive pillar 13Aa' of a first front bump 13A' includes a copper layer 13Aa1 and a nickel layer 13Aa2. The nickel layer 13Aa2 covers the lower surface of the copper layer 13Aa1. The nickel layer 13Aa2 is disposed between the copper layer 13Aa1 and the solder layer 13Ab'.

A thickness of the copper layer 13Aa1 is greater than a thickness of the nickel layer 13Aa2. In an embodiment, the electrical conductivity of the first front bump 13A' can be improved, because the copper layer 13Aa1 made of copper having a lower resistivity than nickel is formed thicker than the nickel layer 13Aa2. Although not shown, an interfacial intermetallic compound may be formed at the interface between the nickel layer 13Aa2 and the solder layer 13Ab'. The nickel layer 13Aa2 may suppress the copper included in the copper layer 13Aa1 from diffusing to the interface between the conductive pillar 13Aa' and the solder layer 13Ab'. Thereby, in an embodiment, the formation of a thick interfacial intermetallic compound can be suppressed.

The side surface of the nickel layer 13Aa2 may protrude more than the side surface of the copper layer 13Aa1 in the horizontal direction. The center of the nickel layer 13Aa2 may vertically overlap with the copper layer 13Aa1, and the flange section of the nickel layer 13Aa2 might not vertically overlap with the copper layer 13Aa1.

A carrier bump 51' includes a copper layer 51a and a nickel layer 51b. The nickel layer 51b covers the upper surface of the copper layer 51a. The nickel layer 51b is disposed between the copper layer 51a and a solder layer 13Ab'. The thickness of the copper layer 51a is greater than the thickness of the nickel layer 51b.

Although not shown, an interfacial intermetallic compound may be formed at the interface between the carrier bump 51' and the solder layer 13Ab' when bonding between the carrier bump 51' and the solder layer 13Ab'. The nickel layer 51b can suppress the copper included in the copper layer 51a from diffusing to the interface between the carrier bump 51' and the solder layer 13Ab'. Thereby, in an embodiment, the generation of a thick interfacial intermetallic compound can be suppressed.

Referring to FIG. 4, a first copper layer 61a of an external connection bump 61 has a width of W1. The maximum width of a first opening OP1-1 of a passivation layer 80-1 has a width of W3. W3 is smaller than W1. The planar area of the first opening OP1-1 of the passivation layer 80-1 may be smaller than the planar area of the external connection bump 61.

The external connection bump 61 is disposed below the carrier bump 51 exposed by the first opening OP1-1 and the passivation layer 80-1 around the first opening OP1-1. The external connection bump 61 vertically overlaps the carrier bump 51 exposed by the first opening OP1-1 and the passivation layer 80-1 around the first opening OP1-1. A first UBM pattern 71a-1 is disposed between the external connection bump 61 and the carrier bump 51, and between the external connection bump 61 and the passivation layer 80-1.

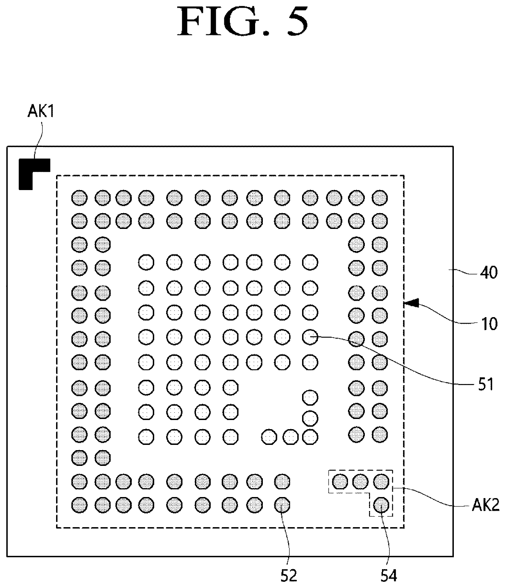

FIG. 5 is a plan view illustrating a chip stack package according to an embodiment of the present disclosure. FIG. 5 is a plan view of the chip stack package viewed from the bottom of the mold member 40.

Referring to FIG. 5, a plurality of bumps 51, 52 and 54 are disposed in an area vertically overlapping with the first semiconductor chip 10. A first alignment key AK1 is disposed on the outside of the area vertically overlapping with the first semiconductor chip 10.

The first alignment key AK1 may have a different plane shape from the bumps 51, 52 and 54. The bumps 51, 52 and 54 may have a circular plane shape, and the first alignment key AK1 may have a planar shape in a shape of a hook or a ' 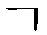 '-shape. FIG. 5 illustrates a case in which the first alignment key AK1 has a planar shape in the shape of a hook, but the planar shape of the first alignment key AK1 may be changed to various shapes such as a square or a triangle.

The bumps include carrier bumps 51, second dummy bumps 52, and second alignment bumps 54. The second alignment bumps 54 constitute a second alignment key AK2. The second alignment bumps 54 have a different arrangement structure from the carrier bumps 51 and the second dummy bumps 52. Accordingly, the semiconductor stack package manufacturing equipment can recognize the second alignment bumps 54 to specify the exact position of the semiconductor chip.

The second alignment key AK2 may play the same role as the first alignment key AK1. FIG. 5 illustrates a case in which both the first alignment key AK1 and the second alignment AK2 are included, but only one of the first alignment key AK1 and the second alignment AK2 may be included.

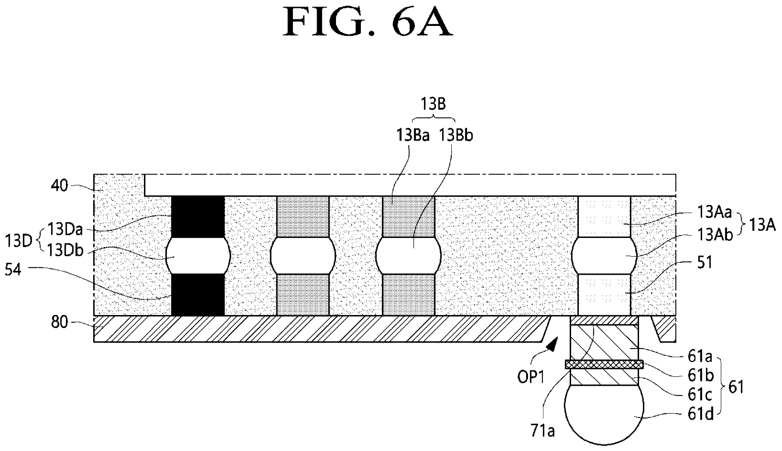

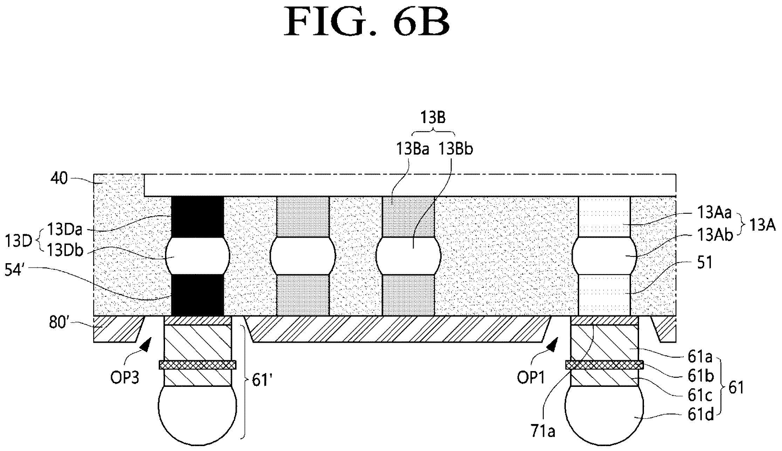

FIG. 6A and FIG. 6B are drawings for explaining a second alignment bump according to embodiments of the present disclosure.

Referring to FIG. 6A, a first alignment bump 13D includes a conductive pillar 13Da and a solder layer 13Db.

The conductive pillar 13Da of the first alignment bump 13D may be formed together with a conductive pillar 13Aa of the first front bump 13A in a process of forming the conductive pillar 13Aa of the first front bump 13A. The conductive pillar 13Da of the first alignment bump 13D may be composed of the same material as the conductive pillar 13Aa of the first front bump 13A. The conductive pillar 13Da of the first alignment bump 13D may have the same size as the conductive pillar 13Aa of the first front bump 13A.

The solder layer 13Db of the first alignment bump 13D may be formed together with the solder layer 13Ab of the first front bump 13A in the process of forming the solder layer 13Ab of the first front bump 13A. The solder layer 13Db of the first alignment bump 13D may be formed of the same material as the solder layer 13Ab of the first front bump 13A.

The second alignment bump 54 may be formed together with the carrier bump 51 in the process of forming the carrier bump 51. The second alignment bump 54 may be formed of the same material as the carrier bump 51. The second alignment bump 54 may have the same size as the carrier bump 51.

The first alignment bump 13D is bonded on the second alignment bump 54. The first alignment bump 13D is disposed over the second alignment bump 54. The first alignment bump 13D vertically overlaps the second alignment bump 54. A solder layer 13Db of the first alignment bump 13D is bonded to the second alignment bump 54. A side surface of the first alignment bump 13D and a side surface of the second alignment bumps 54 are surrounded with a mold member 40. A lower surface of the second alignment bump 54 may be exposed to the lower surface of the mold member 40.

The lower surface of the second alignment bump 54 is covered with a passivation layer 80. The second alignment bump 54 might not be used for input or/and output of data signals, power voltage, and ground voltage. No electrical signal is applied to the second alignment bump 54. The second alignment bump 54 may be electrically floated.

Referring to FIG. 6B, a third opening OP3 is formed in a passivation layer 80' through which the lower surface of a second alignment bump 54' is exposed. An external connection bump 61' may be connected to the second alignment bump 54 exposed through the third opening OP3. The second alignment bump 54' can transmit one of a data signal, a power voltage, and a ground voltage.

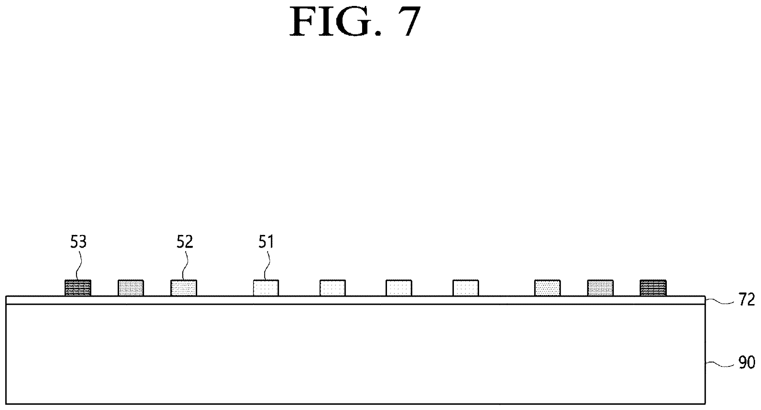

FIG. 7 to FIG. 9 are cross-sectional views illustrating chip stack packages according to embodiments of the present disclosure in process order.

Referring to FIG. 7, a first UBM layer 72 is formed on a first carrier substrate 90, and a carrier bump 51, a second dummy bump 52. A second test bump 53 is formed on the first UBM layer 72. Although not illustrated, an alignment key may be further formed on the first UBM layer 72 during the process of forming the carrier bump 51, the second dummy bump 52, and the second test bump 53.

Although not illustrated, a de-bonding layer may be further formed on the first carrier substrate 90 before forming the first UBM layer 72. In an embodiment, the de-bonding layer may have adhesive characteristics, and may be composed of a material having adhesive strength capable of being reduced by at least one of a chemical treatment and an optical treatment.

The first UBM layer 72 includes a barrier metal layer and a seed layer on the barrier metal layer. The barrier metal layer may include titanium, and the seed layer may include copper. The barrier metal layer and the seed layer may be formed by a deposition method such as sputtering.

The carrier bump 51, the second dummy bump 52, and the second test bump 53 may be formed by forming a first plating resist pattern having opening regions which provide a template for the carrier bump 51, the second dummy bump 52 and the second test bump 53 on the first UBM layer 72, and plating metal into the opening regions of the first plating resist pattern. The first plating resist pattern may be removed after forming the carrier bump 51, the second dummy bump 52, and the second test bump 53.

In an embodiment, each of the carrier bump 51, the second dummy bump 52, and the second test bump 53 may be formed of a nickel layer grown on a seed layer by a plating process. In an embodiment, each of the carrier bump 51, the second dummy bump 52, and the second test bump 53 may be formed of a copper layer grown on a seed layer by a plating process, and a nickel layer grown on a copper layer by a plating process.

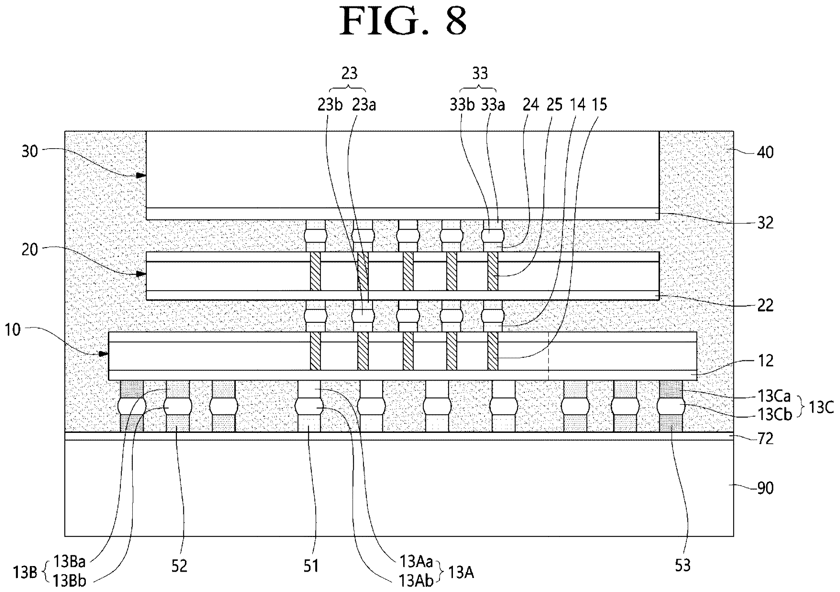

Referring to FIG. 8, the first, second, and third semiconductor chips 10, 20 and 30 are stacked or laminated on a first carrier substrate 90, and a mold member 40 is formed.

The first semiconductor chip 10 includes a first front bump 13A on a lower surface and a first back bump 14 on an upper surface. The first front bump 13A is connected to the first back bump 14 through a wiring of a first wiring structure 12 and a first through-via 15. The first semiconductor chip 10 further includes a first dummy bump 13B and a first test bump 13C on a lower surface of the first semiconductor chip 10.

The first front bump 13A includes a conductive pillar 13Aa and a solder layer 13Ab under the conductive pillar 13Aa. In an embodiment, the conductive pillar 13Aa of the first front bump 13A may be formed of a nickel layer. In an embodiment, the conductive pillar 13Aa of the first front bump 13A may be formed of a copper layer and a nickel layer under the copper layer. The solder layer 13Ab of the first front bump 13A includes a tin-silver alloy.

The first dummy bump 13B includes a conductive pillar 13Ba and a solder layer 13Bb under the conductive pillar 13Ba. The first test bump 13C includes a conductive pillar 13Ca and a solder layer 13Cb under the conductive pillar 13Ca.

The conductive pillar 13Ba of the first dummy bump 13B and the conductive pillar 13Ca of the first test bump 13C are composed of the same material as the conductive pillar 13Aa of the first front bump 13A. The solder layer 13Bb of the first dummy bump 13B and the solder layer 13Cb of the first test bump 13C are composed of the same material as the solder layer 13Ab of the first front bump 13A.

The first semiconductor chip 10 is bonded on a first carrier substrate 90.

The first semiconductor chip 10 may be disposed on the first carrier substrate 90 such that the first front bump 13A, the first dummy bump 13B, and the first test bump 13C of the first semiconductor chip 10 come into contact with the carrier bump 51, the second dummy bump 52, and the second test bump 53 provided on the first carrier substrate 90, respectively. Then, reflow bonding is performed to bond the first front bump 13A, the first dummy bump 13B, and the first test bump 13C of the first semiconductor chip 10 to the carrier bump 51, the second dummy bump 52, and the second test bump 53, respectively.

The second semiconductor chip 20 includes a second front bump 23 on the lower surface and a second back bump 24 on the upper surface. The second front bump 23 includes a conductive pillar 23a and a solder layer 23b under the conductive pillar 23a. The second front bump 23 is connected to the second back bump 24 through a second through-via 25 and a wiring of a second wiring structure 22.

The second semiconductor chip 20 is stacked on a first semiconductor chip 10. The second semiconductor chip 20 is disposed on the first semiconductor chip 10 such that the second front bump 23 of the second semiconductor chip 20 is in contact with the first back bump 14 of the first semiconductor chip 10.

The third semiconductor chip 30 includes a third front bump 33 on the lower surface. The third front bump 33 includes a conductive pillar 33a and a solder layer 33b under the conductive pillar 33a.

The third semiconductor chip 30 is stacked on the second semiconductor chip 20. The third semiconductor chip 30 is disposed on a second semiconductor chip 20 such that a third front bump 33 of the third semiconductor chip 30 is in contact with a second back bump 24 of the second semiconductor chip 20.

A mass reflow bonding process is performed to bond the second semiconductor chip 20 to the first semiconductor chip 10 and to bond the third semiconductor chip 30 to the second semiconductor chip 20. In an embodiment, the mass reflow bonding process can bond a plurality of semiconductor chips together at once, which is advantageous in increasing productivity.

A preliminary mold member is formed to fill the space between the first carrier substrate 90 and the first semiconductor chip 10 and to cover the first, second, and third semiconductor chips 10, 20 and 30. Then, in an embodiment, a grinding process is performed for the upper surface of the preliminary mold member to form the mold member 40 to lower the height of the chip stack package to a target value. In the grinding process, the upper surface of the third semiconductor chip 30 may be exposed, and the third semiconductor chip 30 may be ground together with the preliminary mold member, thereby reducing the thickness of the third semiconductor chip 30.

The mold member 40 may be formed in a molded under-fill (MUF) shape which fills the spaces between the first, second, and third semiconductor chips 10, 20 and 30. Although the spaces between the first, second, and third semiconductor chips 10, 20 and 30 are filled with the mold member 40 in an embodiment, the spaces between the first, second, and third semiconductor chips 10, 20 and 30 may be filled with an under-fill member different from the mold member 40 in an embodiment. In an embodiment, the first, second, and third semiconductor chips 10, 20 and 30 may be attached to each other by a thermal compression bonding method using a non-conductive film, and the non-conductive films may be arranged in the spaces between the first, second, and third semiconductor chips 10, 20 and 30.

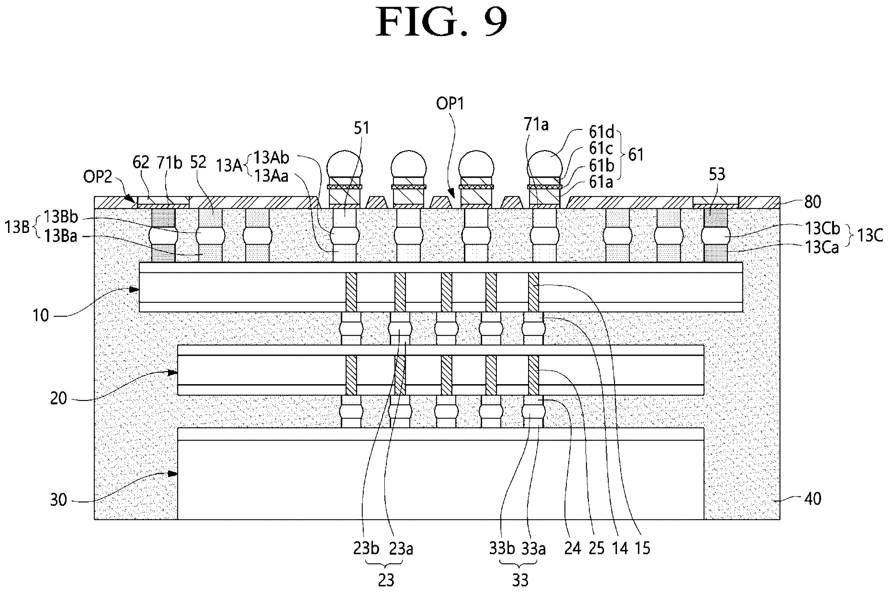

Referring to FIG. 9, the first carrier substrate (90 of FIG. 8) and the first UBM layer (72 of FIG. 8) is removed. In an embodiment, the adhesion of the debonding layer disposed between the first carrier substrate (90 of FIG. 8) and the first UBM layer (72 of FIG. 8) may be reduced by using at least one of a chemical treatment and an optical treatment, and then the first carrier substrate (90 of FIG. 8) may be separated by peeling. In an embodiment, the first carrier substrate (90 of FIG. 8) may be removed by a grinding process. The first UBM layer (72 of FIG. 8) may be removed by an etching process.

Thereafter, a passivation layer 80 is formed on the lower surface of the mold member 40 exposed by the removal of the first UBM layer. The passivation layer 80 covers the dummy bump 52. A first opening OP1 is formed in the passivation layer 80 through which the carrier bump 51 is exposed. A second opening OP2 is formed in the passivation layer 80 through which the second test bump 53 is exposed.

In addition, a second UBM layer is formed on the passivation layer 80 and the open areas by the first opening OP1 and the second opening OP2. A second plating resist pattern having an opening area for providing a template for a test pad 62 is formed on the second UBM layer, and a metal is plated in the opening area of the second plating resist pattern to form a test pad 62. The second plating resist pattern may be removed after forming the test pad 62.

A third plating resist pattern having an opening area which provides a template for an external connection bump 61 is formed on the second UBM layer, and metal is plated in the opening area of the third plating resist pattern to form an external connection bump 61. The third plating resist pattern may be removed after forming the external connection bump 61.

The second UBM layer is a pre-structure for forming the first UBM pattern 71a and second UBM pattern 71b. The second UBM layer may include a barrier metal layer and a seed layer on the barrier metal layer. The barrier metal layer may include titanium, and the seed layer may include copper. The barrier metal layer and the seed layer may be formed by a deposition method such as sputtering. The first UBM pattern 71a and the second UBM pattern 71b may be formed by removing the second UBM layer exposed again by the removal of the third plating resist pattern after removing the third plating resist pattern.

According to the present embodiments, the first semiconductor chip 10 may be fixed to not be moved during the package manufacturing process by bonding the first front bump 13A of the first semiconductor chip 10 to the carrier bump 51 of the first carrier substrate 90. Thereby, in an embodiment, defects due to movement of the first semiconductor chip 10 can be prevented or mitigated. Apart from present embodiments, in a comparison example, a first semiconductor chip is temporarily attached to a carrier substrate with an adhesive layer, the first semiconductor chip may move or tilt in the x, y, and z directions due to heat and pressure applied in subsequent processes such as a process of stacking second and third semiconductor chips on the first semiconductor chip and a molding process, which may cause the semiconductor chips to deviate from their designated positions. Thereby, in the comparison example, appearance defects or contact defects can occur.

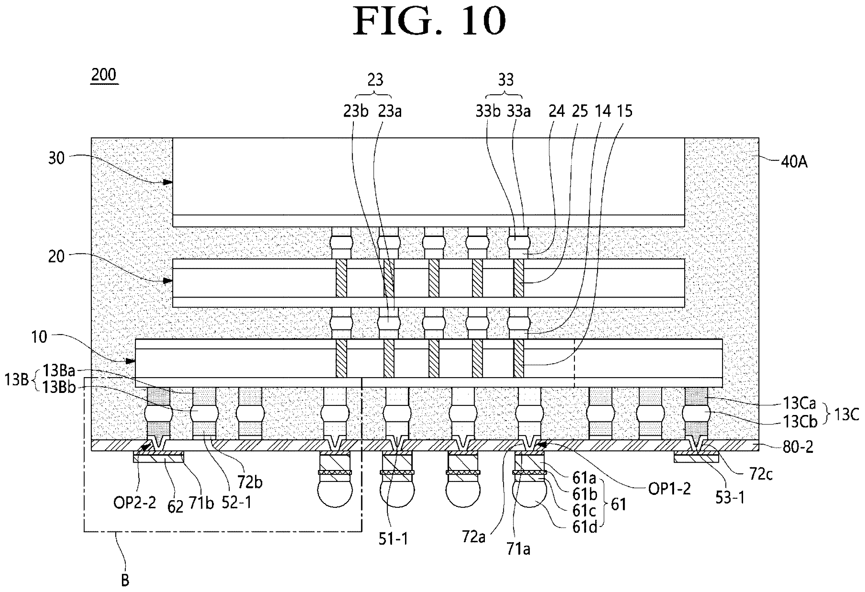

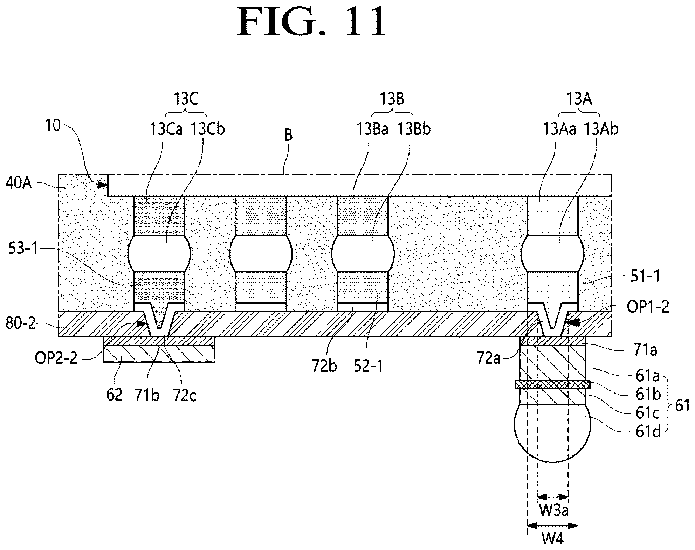

FIG. 10 is a cross-sectional view of a chip stack package according to an embodiment of the present disclosure, FIG. 11 is an enlarged view of section B of FIG. 10, and FIG. 12 and FIG. 13 are cross-sectional views illustrating a first front bump, a carrier bump, an external connection bump, and a passivation layer of a chip stack package according to an embodiment of the present disclosure.

Referring to FIG. 10 and FIG. 11, a first opening OP1-2 of a passivation layer 80-2 has a tapered shape having a width that decreases as it gets farther away from the first semiconductor chip 10. A second opening OP2-2 of the passivation layer 80-2 has a tapered shape having a width that decreases as it gets farther away from the first semiconductor chip 10.

Before forming the first UBM layer on the carrier substrate, a photosensitive material layer may be formed, and the first opening OP1-2 and the second opening OP2-2 may be formed in the photosensitive material layer through an exposure and development process. After the first opening OP1-2 and the second opening OP2-2 are formed, the photosensitive material layer may be hardened through a curing process to form the passivation layer 80-2. During the curing process, the photosensitive material layer may shrink, and a shrinkage width of the photosensitive material layer may increase as the distance from the carrier substrate increases. Accordingly, the widths of the first opening OP1-2 and the second opening OP2-2 may decrease as the distance from the carrier substrate (i.e., first carrier substrate 90 of FIG. 8) decreases. The first opening OP1-2 and the second opening OP2-2 may have a tapered structure having a width that decreases as the distance from the first semiconductor chip 10 disposed on the passivation layer 80-2 increases.

A carrier bump 51-1 vertically overlaps the first opening OP1-2. The lower end of the carrier bump 51-1 is disposed inside the first opening OP1-2. A second test bump 53-1 vertically overlaps the second opening OP2-2. The lower end of the second test bump 53-1 is disposed inside the second opening OP2-2. A second dummy bump 52-1 is disposed on the passivation layer 80-2.

The carrier bump 51-1 has a width of W4. The maximum width of the first opening OP1-2 has a width of W3a which is smaller than W4. The planar area of the first opening OP1-2 may be smaller than the planar area of the carrier bump 51-1. The carrier bump 51-1 vertically overlaps the first opening OP1-2 and the passivation layer 80-2 around the first opening OP1-2.

A third UBM pattern 72a vertically overlaps with the carrier bump 51-1. The third UBM pattern 72a is disposed between the carrier bump 51-1 and an external connection bump 61 and between the carrier bump 51-1 and the passivation layer 80-2.

A fourth UBM pattern 72b vertically overlaps the second dummy bump 52-1.

The planar area of the second opening OP2-2 is smaller than the planar area of the second test bump 53-1. The second test bump 53-1 vertically overlaps with the second opening OP2-2 and the passivation layer 80-2 around the second opening OP2-2. A fifth UBM pattern 72c vertically overlaps the second test bump 53-1. The fifth UBM pattern 72c is disposed between the second test bump 53-1 and the test pad 62, and between the second test bump 53-1 and the passivation layer 80-2.

The external connection bump 61 is formed on the third UBM pattern 72a and the passivation layer 80-2 around the third UBM pattern 72a which are exposed by removing the carrier substrate after removing the carrier substrate. The external connection bump 61 vertically overlaps the third UBM pattern 72a and the passivation layer 80-2 around the third UBM pattern 72a. The first UBM pattern 71a is disposed between the external connection bump 61 and the third UBM pattern 72a, and between the external connection bump 61 and the passivation layer 80-2.

The test pad 62 is formed on the fifth UBM pattern 72c and the passivation layer 80-2 around the fifth UBM pattern 72c which are exposed by removing the carrier substrate after removing the carrier substrate. The test pad 62 vertically overlaps the fifth UBM pattern 72c and the passivation layer 80-2 around the fifth UBM pattern 72c. The second UBM pattern 71b is disposed between the test pad 62 and the fifth UBM pattern 72c, and between the test pad 62 and the passivation layer 80-2.

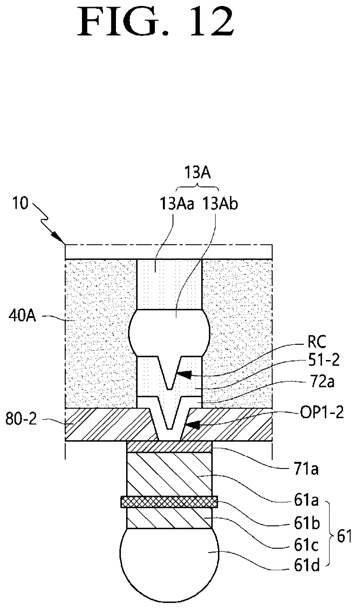

Referring to FIG. 12, the carrier bump 51-2 has a concave section RC on the upper surface contacting a solder layer 13Ab of a first front bump 13A. The concave section RC may have a shape corresponding to the shape of the first opening OP1-2 of the passivation layer 80-2. The solder layer 13Ab of the first front bump 13A is disposed in the concave section RC of the carrier bump 51-2.

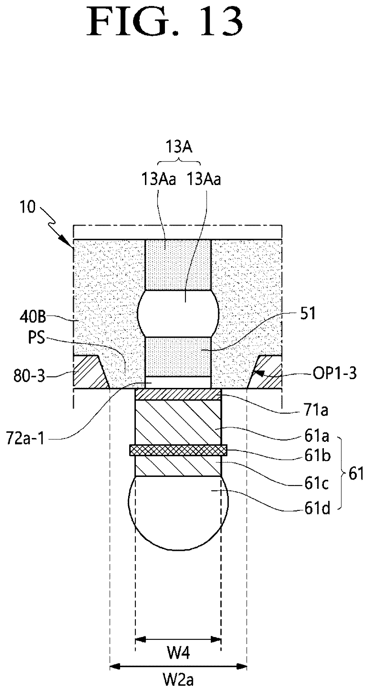

Referring to FIG. 13, the carrier bump 51 has a width of W4. The minimum width of the first opening OP1-3 has a width of W2a which is larger than W4. The planar area of the first opening OP1-3 of the passivation layer 80-3 may be larger than the planar area of the carrier bump 51. The lower section of the carrier bump 51 is disposed inside the first opening OP1-3. The passivation layer 80-3 and the carrier bump 51 are disposed to be spaced apart from each other. The passivation layer 80-3 does not contact the carrier bump 51.

A protrusion PS of a mold member 40B is disposed between the passivation layer 80-3 and the carrier bump 51 inside the first opening OP1-3. The protrusion PS of the mold member 40B is disposed between the passivation layer 80-3 and the carrier bump 51. The protrusion PS of the mold member 40B is in contact with the passivation layer 80-3 and the carrier bump 51.

The planar area of the first opening OP1-3 of the passivation layer 80-3 is larger than the planar area of the external connection bump 61. The external connection bump 61 vertically overlaps the carrier bump 51 and the protrusion PS of the mold member 40. The first UBM pattern 71a is disposed between the external connection bump 61 and a third UBM pattern 72a-1, and between the external connection bump 61 and the protrusion PS of the mold member 40B.

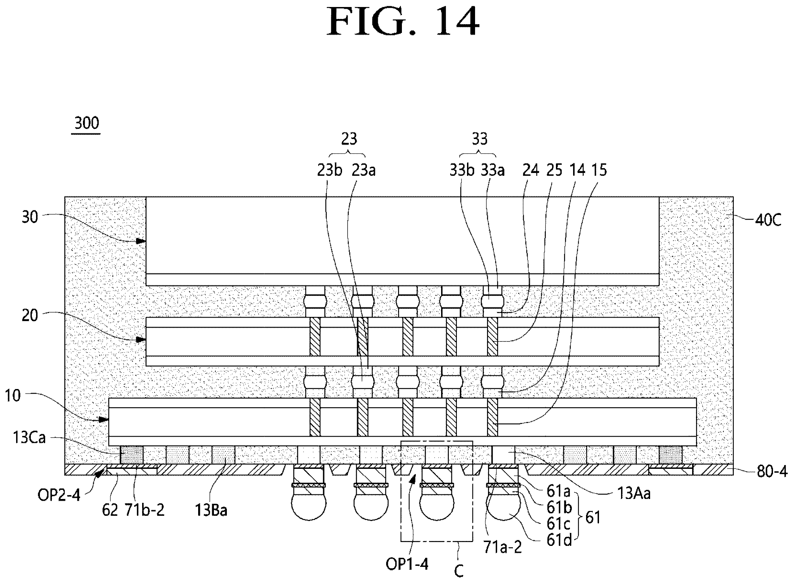

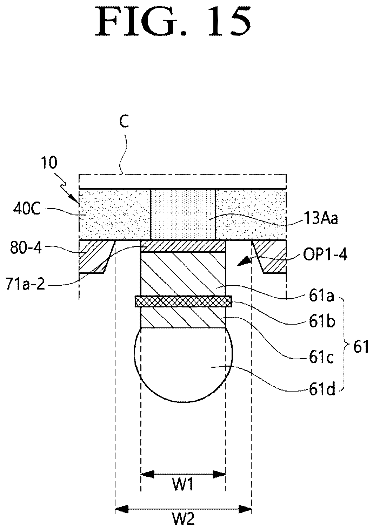

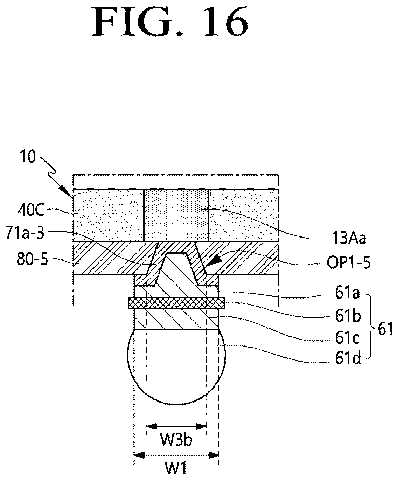

FIG. 14 is a cross-sectional view of a chip stack package according to an embodiment of the present disclosure, FIG. 15 is an enlarged view of a section C of FIG. 14, and FIG. 16 is a cross-sectional view illustrating a section of a chip stack package according to an embodiment of the present disclosure.

Referring to FIG. 14 and FIG. 15, a chip stack package 300 may have a structure in which a conductive pillar 13Aa of a first front bump, a conductive pillar 13Ba of a first dummy bump, and a conductive pillar 13Ca of a first test bump are exposed to the lower surface of a mold member 40C.

The carrier substrate and a first seed layer of FIG. 8 is removed, and the surface exposed by the removal of the first seed layer may be polished to expose the conductive pillar 13Aa of the first front bump, the conductive pillar 13Ba of the first dummy bump, and the conductive pillar 13Ca of the first test bump.

The external connection bump 61 is disposed on the conductive pillar 13Aa of the first front bump. The external connection bump 61 includes a first copper layer 61a, a first nickel layer 61b, a second copper layer 61c, and a solder layer 61d.

A passivation layer 80-4 is disposed on the lower surface of a mold member 40C. A first opening OP1-4 is formed in the passivation layer 80-4 through which the conductive pillar 13Aa of the first front bump is exposed. A second opening OP2-4 is formed in the passivation layer 80-4 through which the conductive pillar 13Ca of the first test bump is exposed. The passivation layer 80-4 covers the conductive pillar 13Ba of the first dummy bump.

The first copper layer 61a of the external connection bump 61 has a width of W1. The minimum width of the first opening OP1-4 of the passivation layer 80-4 has a width of W2 which is greater than W1. The first opening OP1-4 of the passivation layer 80-4 has a larger planar area than the external connection bump 61. The external connection bump 61 and the passivation layer 80-4 is disposed spaced apart from each other. The passivation layer 80-4 does not contact with the external connection bump 61.

The first opening OP1-4 has a reverse tapered structure having a width that increases as the distance from the mold member 40C increases. A photosensitive material layer may be formed on the conductive pillar 13Aa of the mold member 40C and the first front bump. The first opening OP1-4 may be formed in the photosensitive material layer through an exposure and development process. After the first opening OP1-4 is formed, the photosensitive material layer may be hardened through a curing process to form the passivation layer 80-4. During the curing process, the photosensitive material layer may shrink, and the width of the shrinkage of the photosensitive material layer increases as the distance from the carrier substrate increases. Accordingly, the width of the first opening OP1-4 decreases as the distance from the mold member 40C decreases. The first opening OP1-4 has a reverse tapered structure in which the width increases as the distance from the mold member 40C increases.

The external connection bump 61 has a larger planar area than the conductive pillar 13Aa of the first front bump. The external connection bump 61 vertically overlaps the conductive pillar 13Aa and the mold member 40C around the conductive pillar 13Aa.

A first UBM pattern 71a-2 vertically overlaps the external connection bump 61. The first UBM pattern 71a-2 is disposed between the external connection bump 61 and the conductive pillar 13Aa, and between the external connection bump 61 and the mold member 40C.

A test pad 62 is disposed on the conductive pillar 13Ca of the first test bump. The test pad 62 has a larger planar area than the conductive pillar 13Ca of the first test bump. The test pad 62 vertically overlaps the conductive pillar 13Ca and the mold member 40C around the conductive pillar 13Ca. A second UBM pattern 71b-2 is disposed between the test pad 62 and the conductive pillar 13Ca and between the test pad 62 and the mold member 40C.

Referring to FIG. 16, the first copper layer 61a of the external connection bump 61 has a width of W1. The maximum width of a first opening OP1-5 of a passivation layer 80-5 has a width of W3b smaller than W1. The planar area of the first opening OP1-5 may be smaller than the planar area of the external connection bump 61.

The external connection bump 61 vertically overlaps the conductive pillar 13Aa of the first front bump exposed through the first opening OP1-5 and the passivation layer 80-5 around the conductive pillar 13Aa.

The first UBM layer 71a-3 vertically overlaps the external connection bump 61. The first UBM layer 71a-3 is disposed between the external connection bump 61 and the conductive pillar 13Aa, and between the external connection bump 61 and the passivation layer 80-5.

Concepts are disclosed in conjunction with examples and embodiments as described above. Those skilled in the art will understand that various modifications, additions, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the above descriptions. All changes within the meaning and range of equivalency of the claims are included within their scope.

## Claims

1. A chip stack package comprising:
a first semiconductor chip having a front bump on a first surface of the first semiconductor chip;
a second semiconductor chip stacked on a second surface of the first semiconductor chip opposite the first surface;
a carrier bump bonded to the front bump;
a mold member surrounding the first semiconductor chip and the second chip, and the carrier bump; and
an external connection bump disposed on the carrier bump.

2. The chip stack package of claim 1, further comprising:
a first test bump on the first surface of the first semiconductor chip;
a second test bump bonded to the first test bump; and
a test pad disposed on the second test bump,
wherein the first test bump and the second test bump are surrounded with the mold member.

3. The chip stack package of claim 1, wherein the front bump includes a nickel layer and a solder layer on the nickel layer, and the solder layer is bonded to the carrier bump.

4. The chip stack package of claim 1, wherein the front bump includes a copper layer, a nickel layer on the copper layer, and a solder layer on the nickel layer, and the solder layer is bonded to the carrier bump.

5. The chip stack package of claim 4, wherein a thickness of the copper layer is greater than a thickness of the nickel layer.

6. The chip stack package of claim 1, wherein the carrier bump includes nickel layer.

7. The chip stack package of claim 1, wherein the carrier bump includes a copper layer and a nickel layer on the copper layer.

8. The chip stack package of claim 7, wherein a thickness of the copper layer is greater than a thickness of the nickel layer.

9. The chip stack package of claim 1,
wherein the front bump includes a first copper layer, a first nickel layer on the first copper layer, and a solder layer on the first nickel layer,
wherein the carrier bump includes a second copper layer and a second nickel layer on the second copper layer, and
wherein the solder layer is in contact with the first nickel layer and the second nickel layer.

10. The chip stack package of claim 1, further comprising a passivation layer disposed on the mold member and having a first opening exposing the carrier bump.

11. The chip stack package of claim 1, further comprising an alignment key,
wherein the alignment key includes a bump positioned at substantially the same height level as the carrier bump.

12. The chip stack package of claim 1, wherein further comprising an alignment key,
wherein the alignment key includes a first alignment bump disposed on the first surface of the first semiconductor chip, and a second alignment bump bonded to the first alignment bump,
wherein the first alignment bump and the second alignment bump are surrounded with the mold member.

13. The chip stack package of claim 1, comprising a plurality of carrier bumps including the carrier bump,
wherein the plurality of carrier bumps include a first group of carrier bumps not included in an alignment key and a second group of carrier bumps included in the alignment key,
wherein an arrangement structure of the carrier bumps of the second group is different from an arrangement structure of the carrier bumps of the first group.

14. The chip stack package of claim 1, wherein the first semiconductor chip further includes a first dummy bump on the first surface, and a second dummy bump bonded to the first dummy bump,
wherein the first dummy bump and the second dummy bump are surrounded with the mold member.

15. The chip stack package of claim 14, comprising a plurality of second dummy bumps including the second dummy bump,
wherein the plurality of second dummy bumps include second dummy bumps of a first group not included in an alignment key and second dummy bumps of a second group included in the alignment key,
wherein an arrangement structure of the second dummy bumps of the second group is different from an arrangement structure of the second dummy bumps of the first group.

16. A manufacturing method of a chip stack package comprising:
forming a carrier bump on a carrier substrate;
stacking a first semiconductor chip having a front bump on the carrier substrate and bonding the front bump to the carrier bump;
stacking a second semiconductor chip on the first semiconductor chip;
forming a mold member surrounding the first semiconductor chip, the second chip, and the carrier bump on the carrier substrate;
removing the carrier substrate; and
forming an external connection bump on the carrier bump exposed by removing the carrier substrate.

17. The manufacturing method of claim 16, wherein the front bump includes a nickel layer and a solder layer on the nickel layer,
wherein the front bump is bonded to the carrier bump using the solder layer.

18. The manufacturing method of claim 16, wherein the carrier bump includes a first nickel layer, and the front bump includes a second nickel layer and a solder layer on the first nickel layer,
wherein the solder layer is in contact with the first nickel layer.

19. The manufacturing method of claim 16, wherein the carrier bump includes a first copper layer and a first nickel layer on the first copper layer,
wherein the front bump includes a second copper layer, a second nickel layer on the second copper layer, and a solder layer on the second nickel layer,
wherein the solder layer is in contact with the first nickel layer.
